# EUROPEAN PATENT SPECIFICATION

(11) **EP 3 734 655 B1**
(45) Date of publication and mention of the grant of the patent: **26.01.2022**
(21) Application number: 19213498.9
(22) Date of filing: 04.12.2019
(51) Int. Cl.: H01L 23/367, F28D 1/02

(54) **HIGH EFFICIENCY INTEGRATED AX-RADIAL BLOWER AND HEAT EXCHANGER**
HOCHEFFIZIENTER INTEGRIERTER AX-RADIALER BLÄSER UND WÄRMETAUSCHER
SOUFFLEUSE RADIALE AX INTÉGRÉE HAUTE EFFICACITÉ ET ÉCHANGEUR DE CHALEUR

(30) Priority: 30.04.2019 US 201916399585
(43) Date of publication of application: 04.11.2020
(73) Proprietor: Hamilton Sundstrand Corporation, Charlotte, NC 28217-4578 (US)
(72) Inventor: HALBE, Chaitanya Vishwajit, Manchester, CT 06042 (US); PEARSON, Matthew Robert, Hartford, CT 06103 (US)
(74) Representative: Dehns

(56) References cited:
- EP-A2- 2 410 564
- WO-A1-01/43519
- US-A- 5 132 780
- US-A- 5 661 638
- US-A1- 2012 050 990

## Description

### BACKGROUND

The present disclosure relates to a heat transfer device, and in particular, to a blower and heat exchanger for cooling electronics and other cooling applications.

Heat sinks are commonly used in electronics and other systems to conductively remove heat. To further increase heat transfer across the heat sink, a blower or fan is used to blow air across the heat sink to remove heat from the heat sink via convection. Cooling fins or rods are included on the heat sink to increase the surface area of the heat sink that is in contact with the blown air, thereby increasing the heat transfer between the heat sink and the air. Additional improvements are needed to further increase the heat transfer from the heat sink to the air. Heat exchangers are disclosed in US 5,132,780, EP 2410564 and WO 01/43519

US 5,661,638 discloses a heat transfer device according to the preamble of claim 1.

### SUMMARY

In one aspect of the disclosure, a heat transfer device is provided as defined by claim 1.

[DELETED]

[DELETED]

### BRIEF DESCRIPTION OF THE DRAWINGS

FIG. 1 is a perspective view of a heat transfer device with a blower and a heat exchanger not forming part of the invention.
FIG. 2 is a cross-sectional view of the blower and the heat exchanger from FIG. 1.
FIG. 3 is a cross-sectional view of a heat transfer device according to the invention.

While the above-identified drawing figures set forth one or more embodiments other embodiments are also contemplated. Like reference numerals identify similar structural elements.

### DETAILED DESCRIPTION

This disclosure relates to a heat transfer device with a heat exchanger having a base and axial-radial fins connected to the base. The fins define air flow channels with each air flow channel having an inlet radially inward of an outlet relative a center axis of the heat exchanger. Both the fins and the air flow channels turn between the inlets and the outlets of the air flow channels relative the center axis and a radial direction. Because the fins and the air flow channels turn relative the center axis and a radial direction, the length and surface area of the fins and the air flow channels are longer than fins and passages on conventional heat exchangers. The additional length and surface area of the fins and the air flow channels allows the heat exchanger to transfer more heat than conventional heat exchangers. The turn in the fins and the air flow channels also allows the air flow channels to smoothly transition an axial flow or a mixed flow of cooling air into a radial flow, such that the heat exchanger can be paired with an axial blower or a mixed flow rotor. The heat transfer device is discussed below with reference to the figures.

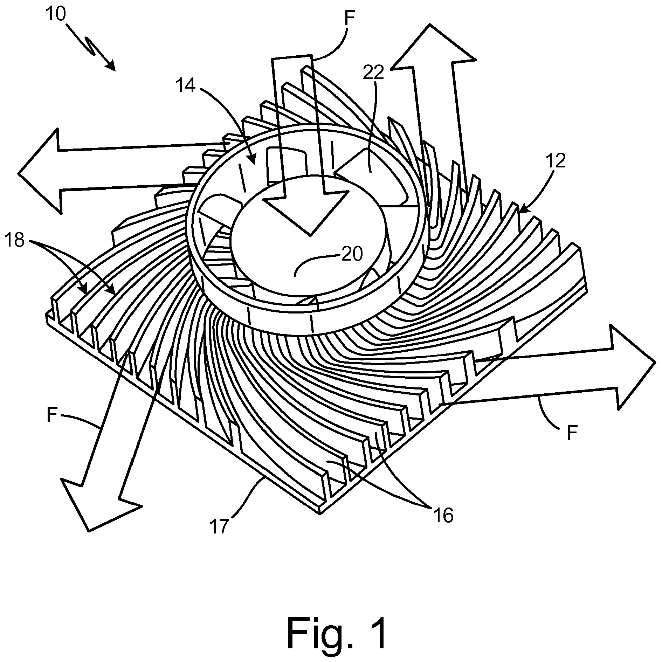

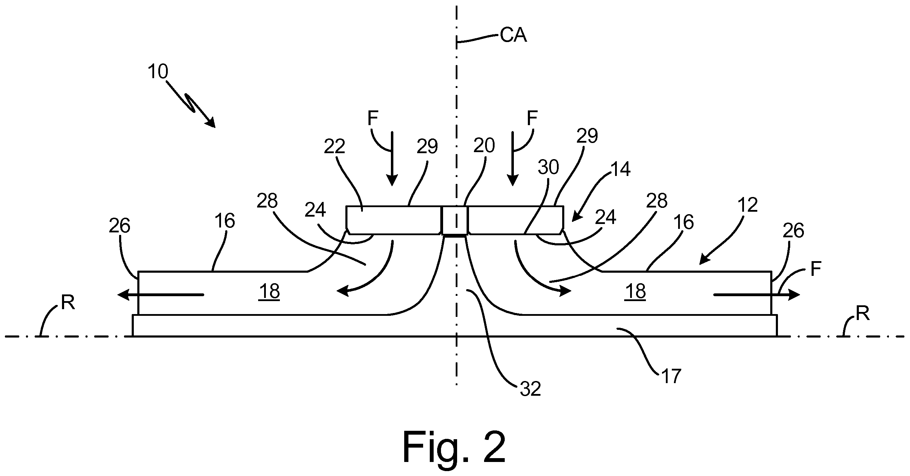

FIGS. 1 and 2 will be discussed concurrently. FIG. 1 is a perspective view of heat transfer device 10 with heat exchanger 12 and blower 14. FIG. 2 is a cross-sectional schematic of heat transfer device 10. As shown collectively in FIGS. 1 and 2, heat exchanger 12 includes fins 16, base 17, air flow channels 18, and center axis CA. Blower 14 includes rotor 20 and fan blades 22. As shown best in FIG. 2, each of fins 16 includes leading edge 24, trailing edge 26, and turn 28. Fan blades 22 include leading edge 29 and trailing edge 30. Base 17 includes conical hub 32. Air flow F and radial direction R are also referenced in FIG. 2.

In the embodiment of FIGS. 1 and 2, heat exchanger 12 is an axial-to-radial heat sink that turns air flow F from an axial flow direction to a radial flow direction. Base 17 is a relatively flat plate extending radially outward from center axis CA, with conical hub 32 extending axially on center axis CA away from the rest of base 17. As shown in FIG. 1, base 17 can have a square perimeter but can be another shape (such as circular) in other embodiments. Fins 16 are connected to base 17 and are spaced circumferentially apart from one another about center axis CA to form and define air flow channels 18. As shown best in FIG. 1, each air flow channel 18 is formed between two fins 16 and base 17. A cover (not shown) can also be attached to heat exchanger 12 opposite base 17 to further enclose air flow channels 18.

Each fin 16 extends between leading edge 24 and trailing edge 26. In the embodiment of FIG. 1 and 2, leading edge 24 of each fin 16 is positioned on conical hub 32 and extends away from center axis CA in the radial direction R. Leading edge 24 can also lean or curve circumferentially relative center axis CA as leading edge 24 extends away from conical hub 32 and center axis CA. Trailing edge 26 of each fin 16 is radially outward from leading edge 24 and near a perimeter of base 17. Trailing edge 26 extends axially from base 17. Trailing edge 26 can also lean or curve circumferentially relative center axis CA as trailing edge 26 extends axially from base 17. A body of each fin 16 extends from leading edge 24 to trailing edge 26. The body of each fin 16 can curve (as shown in FIG. 1) circumferentially relative center axis CA as the body of each fin 16 extends from leading edge 24 to trailing edge 26. Turn 28 is formed on each of fins 16 and curves and transitions the body of each fin 16 from the axial direction (represented by center axis CA) to the radial direction R. As shown best in FIG. 2, turn 28 is supported and connected to conical hub 32 downstream from leading edge 24.

Air flow channels 18 follow the profile of fins 16. Each air flow channel 18 begins with an inlet at leading edge 24. As air flow channel 18 progresses axially along fin 16 away from the inlet and leading edge 24, air flow channel 18 turns and bends from the axial direction to the radial direction R due to turn 28. Air flow channel 18 then progresses radially outward from center axis CA and terminates at an outlet at trailing edge 26 of fin 16. As air flow channel 18 extends axially, turns to the radial direction R, and progresses radially outward from the inlet and center axis CA, air flow channel 18 can curve circumferentially relative center axis CA (as shown in FIG. 1) in accordance with the curved geometry of fins 16.

Blower 14 is connected to heat exchanger 12 and is coaxial with center axis CA. In the embodiments of FIGS. . 1 and 2, blower 14 is an axial fan that generates air flow F in an axial direction by rotating rotor 20 and fan blades 22. As an axial fan, blower 14 is typically more efficient than a centrifugal blower. Blower 14 includes an electrical motor (not shown) that is connected to rotor 20 and configured to rotate rotor 20 and fan blades 22. Each fan blade 22 extends between leading edge 29 and trailing edge 30, with leading edge 29 being positioned near an inlet of blower 14 and trailing edge 30 being positioned near an outlet of blower 14. The outlet of blower 14 is fluidically connected to an inlet of air flow channels 18 of heat exchanger 12.

During operation, base 17 of heat exchanger 17 is attached to a heat producing device (not shown), such as a power transformer, a microprocessor, or any other device that requires heat dissipation, and base 17 and fins 16 absorb heat from the heat producing device via conduction. Blower 14 forces air flow F axially into air flow channels 18 and through air flow channels 18. As air flow F flows through air flow channels 18, heat is transferred from base 17 and fins 16 into air flow F. The heat leaves heat exchanger 12 when air flow F exits air flow channels 18. Heat exchanger 12 is more efficient than prior art radial heat exchangers because fins 16 cover more of base 17 and thus have more surface area. In prior art radial heat exchangers, a substantial portion of the base is clear of fins to accommodate a blower. Furthermore, fins 16 have more surface area because fins 16 extend in the radial direction R and axially. While the embodiment of FIGS. 1 and 2 show blower 14 as an axial fan, heat exchanger 12 can be modified to accommodate a blower 14 that is a mixed flow fan.

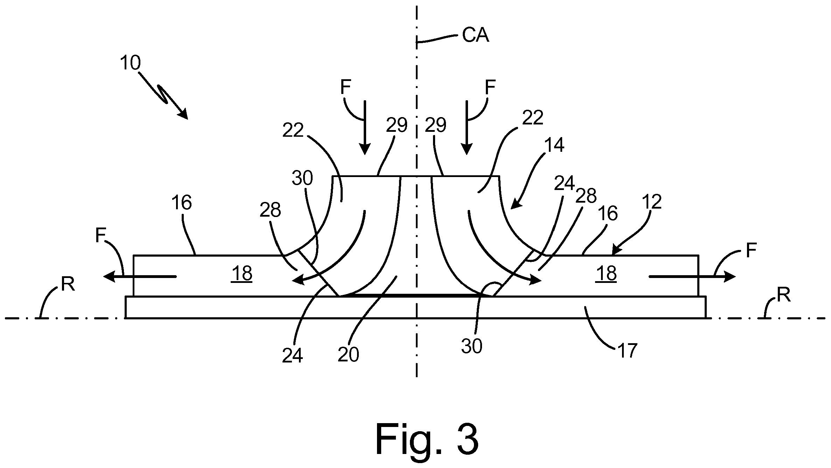

FIG. 3 is a cross-sectional view of another embodiment disclosing the invention and describing a heat transfer device 10 with heat exchanger 12 and blower 14. As shown in FIG. 3, blower 14 is a mixed flow fan that pulls air flow F axially into blower 14 and pushes air flow F out of blower 14 at an angle between the radial direction R and center axis CA. As a mixed flow fan, blower 14 is more efficient than a centrifugal blower. Trailing edge 30 of each fan blade 22 and the outlet of blower 14 are both angled relative center axis CA and the radial direction R.

Each fin 16 extends between leading edge 24 and trailing edge 26. In the embodiment of FIG. 3, leading edge 24 of each fin 16 is positioned on base 17 and extends axially away from base 17 and away from center axis CA in the radial direction R. Leading edge 24 can also lean or curve circumferentially relative center axis CA as leading edge 24 extends away from base 17 and center axis CA. Trailing edge 26 of each fin 16 is radially outward from leading edge 24 and near a perimeter of base 17. Trailing edge 26 extends axially from base 17. Trailing edge 26 can also lean or curve circumferentially relative center axis CA as trailing edge 26 extends axially from base 17. A body of each fin 16 extends from leading edge 24 to trailing edge 26. The body of each fin 16 can curve circumferentially relative center axis CA as the body of each fin 16 extends from leading edge 24 to trailing edge 26. Turn 28 is formed on each of fins 16 and curves and transitions the body of each fin 16 from the mixed axial and radial direction of leading edge 24 to the radial direction R.

Air flow channels 18 follow the profile of fins 16. Each air flow channel 18 begins with a mixed flow inlet at leading edge 24. As air flow channel 18 progresses axially and radially along fin 16 away from the inlet and leading edge 24, air flow channel 18 turns and bends from the mixed axial-radial direction to the radial direction R due to turn 28. Air flow channel 18 then progresses radially outward from center axis CA and terminates at an outlet at trailing edge 26 of fin 16. As air flow channel 18 progresses from the inlet to the outlet, air flow channel 18 can curve circumferentially relative center axis CA (similar to the embodiment shown in FIG. 1) in accordance with the curved geometry of fins 16.

Any relative terms or terms of degree used herein, such as "substantially", "essentially", "generally", "approximately", and the like, should be interpreted in accordance with and subject to any applicable definitions or limits expressly stated herein. In all instances, any relative terms or terms of degree used herein should be interpreted to broadly encompass any relevant disclosed embodiments as well as such ranges or variations as would be understood by a person of ordinary skill in the art in view of the entirety of the present disclosure, such as to encompass ordinary manufacturing tolerance variations, incidental alignment variations, transitory vibrations and sway movements, temporary alignment or shape variations induced by operational conditions, and the like.

While the invention has been described with reference to an exemplary embodiment(s), it will be understood by those skilled in the art that various changes may be made and equivalents may be substituted for elements thereof without departing from the scope of the invention as defined by the claims. Therefore, it is intended that the invention not be limited to the particular embodiment(s) disclosed, but that the invention will include all embodiments falling within the scope of the appended claims.

## Claims

1. A heat transfer device (10) comprising:
a heat exchanger (12) comprising:
a base (17);
a center axis (CA) extending through the base such that the base extends outward from the center axis in a radial direction (R); and
a plurality of fins (16) connected to the base and defining a corresponding plurality of air flow channels (18) supported on the base, wherein each of the plurality of air flow channels comprises:
an inlet; and
an outlet radially outward from the inlet relative the center axis, and
wherein each of the plurality of air flow channels (18) turns between the
inlet and the outlet relative the center axis (CA) and the radial
direction, and
a blower (14) connected to the heat exchanger and coaxial with the center axis, wherein an exit of the blower is fluidically connected to the inlet of each of the plurality of air flow channels **characterized in that** each of the plurality of air flow channels (18) is a
mixed flow channel with the inlet angled relative the center axis (CA) and the radial direction (R), and the outlet facing radially outward; and
wherein the blower (14) is a mixed flow fan such that the exit of the blower is angled relative the center axis and the radial direction.

2. The heat transfer device of claim 1, wherein each of the plurality of air flow channels (18) extends axially from the inlet and extends radially through the outlet relative the center axis.

3. The heat transfer device of any preceding claim, wherein each of the plurality of fins (16) curves circumferentially relative the center axis.

4. The heat transfer device (10) of any preceding claim, wherein each of the plurality of fins comprises:
a leading edge (24);
a trailing edge (26) positioned radially outward from the leading edge; and
a fin body extending between the leading edge and the trailing edge, wherein the fin body turns relative the center axis and the radial direction between the leading edge and the trailing edge.

5. The heat transfer device of any preceding claim, further comprising:
a turn (28) between the inlet and the outlet, wherein the turn bends
the respective air flow channel (18) relative the center axis and
the radial direction.

6. The heat transfer device of claim 5, wherein each of the plurality of air flow channels is a mixed flow channel with the inlet at the turn (28) and angled relative the center axis and the radial direction, and the outlet facing radially outward, and wherein the blower is a mixed flow fan such that the exit of the blower is angled relative the center axis and the radial direction.

## Patentansprüche

1. Wärmeübertragungsvorrichtung (10), die Folgendes umfasst:
einen Wärmetauscher (12), der Folgendes umfasst:
eine Basis (17);
eine Mittelachse (CA), die sich derart durch die Basis erstreckt, dass sich die Basis von der Mittelachse in einer radialen Richtung (R) nach außen erstreckt; und
eine Vielzahl von Stegen (16), die mit der Basis verbunden ist und eine entsprechende Vielzahl von Luftströmungskanälen (18) definiert, die auf der Basis getragen ist, wobei jeder der Vielzahl von Luftströmungskanälen Folgendes umfasst:
einen Einlass; und
einen Auslass radial nach außen von dem Einlass relativ zu der Mittelachse, und wobei sich jeder der Vielzahl von Luftströmungskanälen (18) zwischen dem Einlass und dem Auslass relativ zu der Mittelachse (CA) und der radialen Richtung windet, und
ein Gebläse (14), das mit dem Wärmetauscher verbunden und koaxial zu der Mittelachse ist, wobei ein Ausgang des Gebläses mit dem Einlass jedes der Vielzahl von Luftströmungskanälen fluidverbunden ist, **dadurch gekennzeichnet, dass** jeder der Vielzahl von Luftströmungskanälen (18) ein Mischströmungskanal ist, wobei der Einlass relativ zu der Mittelachse (CA) und der radialen Richtung (R) abgewinkelt ist und der Auslass radial nach außen weist; und
wobei das Gebläse (14) ein Mischströmungslüfter ist, sodass der Ausgang des Gebläses relativ zu der Mittelachse und der radialen Richtung abgewinkelt ist.

2. Wärmeübertragungsvorrichtung nach Anspruch 1, wobei sich jeder der Vielzahl von Luftströmungskanälen (18) axial von dem Einlass erstreckt und sich radial durch den Auslass relativ zu der Mittelachse erstreckt.

3. Wärmeübertragungsvorrichtung nach einem der vorstehenden Ansprüche, wobei jeder der Vielzahl von Stegen (16) in Umfangsrichtung relativ zu der Mittelachse gekrümmt ist.

4. Wärmeübertragungsvorrichtung (10) nach einem der vorstehenden Ansprüche, wobei jeder der Vielzahl von Stegen Folgendes umfasst:
eine Anströmkante (24);
eine Abströmkante (26), die von der Anströmkante radial nach außen positioniert ist; und
einen Stegkörper, der sich zwischen der Anströmkante und der Abströmkante erstreckt, wobei sich der Stegkörper relativ zu der Mittelachse und der radialen Richtung zwischen der Anströmkante und der Abströmkante windet.

5. Wärmeübertragungsvorrichtung nach einem der vorstehenden Ansprüche, ferner umfassend:
eine Windung (28) zwischen dem Einlass und dem Auslass, wobei die Windung den jeweiligen Luftströmungskanal (18) relativ zu der Mittelachse und der radialen Richtung biegt.

6. Wärmeübertragungsvorrichtung nach Anspruch 5, wobei jeder der Vielzahl von Luftströmungskanälen ein Mischströmungskanal ist, wobei der Einlass an der Windung (28) liegt und relativ zu der Mittelachse und der radialen Richtung abgewinkelt ist und der Auslass radial nach außen weist, und wobei das Gebläse ein Mischströmungslüfter ist, sodass der Ausgang des Gebläses relativ zu der Mittelachse und der radialen Richtung abgewinkelt ist.

## Revendications

1. Dispositif de transfert de chaleur (10) comprenant :
un échangeur de chaleur (12) comprenant :
une base (17) ;
un axe central (CA) s'étendant à travers la base de sorte que la base s'étend vers l'extérieur depuis l'axe central dans une direction radiale (R) ; et
une pluralité d'ailettes (16) reliées à la base et définissant une pluralité correspondante de canaux d'écoulement d'air (18) supportés sur la base, dans lequel chacun de la pluralité de canaux d'écoulement d'air comprend :
une entrée ; et
une sortie radialement vers l'extérieur depuis l'entrée par rapport à l'axe central, et dans lequel chacun de la pluralité de canaux d'écoulement d'air (18) tourne entre l'entrée et la sortie par rapport à l'axe central (CA) et à la direction radiale, et
une souffleuse (14) reliée à l'échangeur de chaleur et coaxiale à l'axe central, dans lequel une sortie de la souffleuse est reliée fluidiquement à l'entrée de chacun de la pluralité de canaux d'écoulement d'air **caractérisé en ce que** chacun de la pluralité de canaux d'écoulement d'air (18) est un canal d'écoulement mixte avec l'entrée inclinée par rapport à l'axe central (CA) et à la direction radiale (R), et la sortie étant tournée radialement vers l'extérieur ; et
dans lequel la souffleuse (14) est une soufflante à écoulement mixte de sorte que la sortie de la souffleuse est inclinée par rapport à l'axe central et à la direction radiale.

2. Dispositif de transfert de chaleur selon la revendication 1, dans lequel chacun de la pluralité de canaux d'écoulement d'air (18) s'étend axialement depuis l'entrée et s'étend radialement à travers la sortie par rapport à l'axe central.

3. Dispositif de transfert de chaleur selon une quelconque revendication précédente, dans lequel chacune de la pluralité d'ailettes (16) s'incurve circonférentiellement par rapport à l'axe central.

4. Dispositif de transfert de chaleur (10) selon une quelconque revendication précédente, dans lequel chacune de la pluralité d'ailettes comprend :
un bord d'attaque (24) ;
un bord de fuite (26) positionné radialement vers l'extérieur du bord d'attaque ; et
un corps d'ailette s'étendant entre le bord d'attaque et le bord de fuite, dans lequel le corps d'ailette tourne par rapport à l'axe central et à la direction radiale entre le bord d'attaque et le bord de fuite.

5. Dispositif de transfert de chaleur selon une quelconque revendication précédente, comprenant en outre :
une spire (28) entre l'entrée et la sortie, dans lequel la spire plie le canal d'écoulement d'air respectif (18) par rapport à l'axe central et à la direction radiale.

6. Dispositif de transfert de chaleur selon la revendication 5, dans lequel chacun de la pluralité de canaux d'écoulement d'air est un canal d'écoulement mixte avec l'entrée au niveau de la spire (28) et inclinée par rapport à l'axe central et à la direction radiale, et la sortie étant tournée radialement vers l'extérieur, et dans lequel la souffleuse est une soufflante à écoulement mixte de sorte que la sortie de la souffleuse est inclinée par rapport à l'axe central et à la direction radiale.
